# EUROPEAN PATENT APPLICATION

(11) **EP 2 536 025 A1**
(43) Date of publication of application: **19.12.2012**
(21) Application number: 11852222.6
(22) Date of filing: 27.10.2011
(51) Int. Cl.: H03F 1/07

(54) **POWER AMPLIFIER DEVICE AND POWER AMPLIFIER CIRCUIT**

(30) Priority: 29.04.2011 CN 201110111756
(71) Applicant: ZTE Corporation, Shenzhen, Guangdong 518057 (CN)
(72) Inventor: CHEN, Huazhang, Shenzhen, Guangdong 518057 (CN); CUI, Xiaojun, Shenzhen, Guangdong 518057 (CN); LIU, Jianli, Shenzhen, Guangdong 518057 (CN); AN, Jinyuan, Shenzhen, Guangdong 518057 (CN)
(74) Representative: Bokinge, Ole
(86) International application number: PCT/CN2011/081438
(87) International publication number: WO 2012/146014

(57) **Abstract**

The present invention relates to a power amplifier apparatus and power amplifier circuit thereof, and the power amplifier circuit uses the Doherty circuit structure, and the power amplifier circuit uses high voltage heterojunction bipolor transistor (HVHBT) power amplifiers to achieve a carrier amplifier and a peak amplifier of the Doherty circuit structure. The power amplifier apparatus and power amplifier circuit thereof in the present invention improves the efficiency of the power amplification.

## Description

### Technical Field

The present invention relates to the field of communications, and more especially, to a power amplifier apparatus and power amplification circuit thereof in the field of communication.

### Background of the Related Art

In the face of increasingly fierce competition in the market, the efficiency of the base station products has become the focus of competition in the industry, and the improvement of the efficiency of the main component-power amplifier that determines the efficiency of the base station has become a top priority, and the industry has invested in research on the efficiency improvement technologies, wherein the Doherty technology is a mature technology that is most widely used, and the power amplifier manufacturers have begun producing and applying the Doherty power amplifiers in mass, and how to further improve the efficiency in this technology is particularly important.

The Doherty technology was invented by W.H.Doherty in 1936, it was originally used in traveling wave tubes to provide high power transmitters for broadcasting, and its structure is simple and highly efficient.

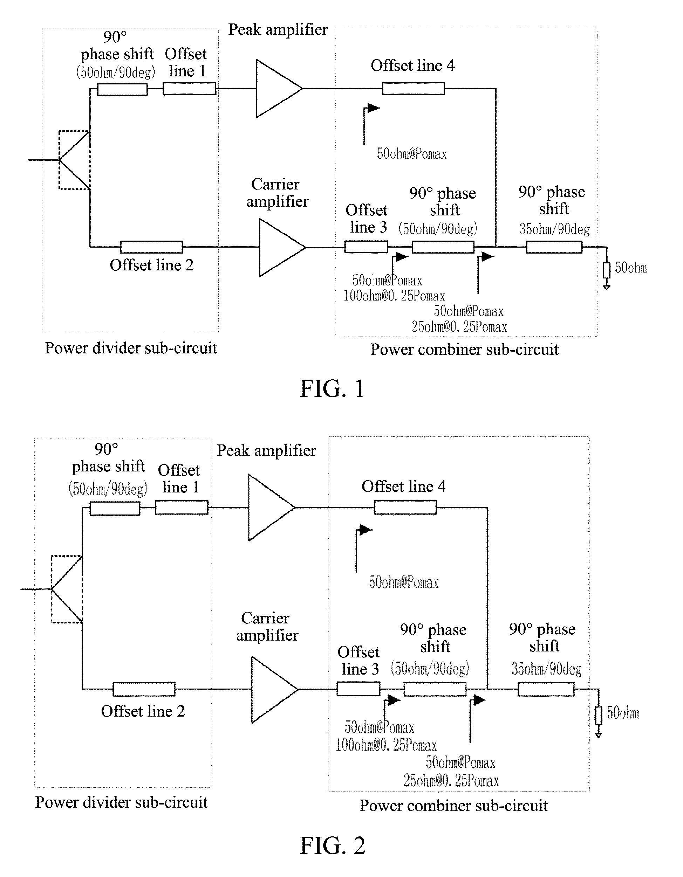

The conventional Doherty structure is composed of two power amplifiers: a main power amplifier (also called as the carrier power amplifier) and an auxiliary power amplifier (also known as Peak Power Amplifier), wherein the carrier power amplifier works in Class B or AB, and the peak power amplifier works in Class C. The two power amplifiers do not work in turns, but the carrier power amplifier works all the time, and the peak power amplifier only works when the preset peak is reached. The 90 degree - a quarter of wavelength line after the carrier power amplifier is for impedance transformation, and its purpose is to play the role of reducing the apparent impedance of the carrier power amplifier when the peak power amplifier works, thus to ensure that the active load impedance composed of the peak power amplifier and the subsequent circuits reduces when the peak power amplifier works, thus the output current of the carrier power amplifier is amplified. Due to the a quarter of wavelength line after the carrier power amplifier output, in order to make the outputs of the two power amplifiers in phase, 90° phase shift is also needed before the peak power amplifier, as shown in FIG. 1.

The carrier power amplifier works in Class B, when the input signal is relatively small, only the carrier power amplifier is in working condition; when the output voltage of the tube reaches the peak saturation point, the efficiency can reach 78.5% in theory. If the excitation is doubled at this time, the tube is already saturated when a half of the peak value is reached, and the efficiency also reaches the maximum 78.5%, at this time, the peak power amplifier also begins to work together with the carrier power amplifier. The introduction of the peak power amplifier makes the load reduced from the perspective of the carrier power amplifier, and since the function of peak power amplifier for the load is equivalent to be series with one negative impedance, even if the output voltage of the carrier power amplifier is saturated and constant, the output power continues to increase (the current flowing through the load is larger) due to the reduction of load. When the excitation peak is reached, the peak power amplifier also reaches the maximum point of its own efficiency, and the total efficiency of two power amplifiers is much higher than the efficiency of a single power amplifier in class B. The maximum efficiency 78.5% of a single power amplifier in class B appears at the peak value, but currently the efficiency 78.5% appears at a half of the peak value, so this system architecture can reach to a very high efficiency (each amplifier reaches its maximum output efficiency).

Due to the requirements of the base station system on set-top output power, the gain of RF power amplifier needs to be in the dozens of dB, thus one stage amplification is not enough, generally 3-4 stage amplification is needed, that is, the pre-driver, the driver and the final stage. Currently, the link structure commonly used in the industry is as follows: the pre-driver stage uses the RF small-signal amplifier, and its working mode is CLASS A; the driver and final stages use the same type of RF power amplifiers (currently, the industry uses the LDMOS devices), the working mode of the driver stage is CLASS AB, and the final stage is the Doherty structure.

With the industry's green concept being put forward, the requirements of the operators on the efficiency of the communication system is almost harsh, even with the advanced Doherty technology, the power amplification efficiency is still unable to meet their increasing demands, therefore it is necessary to make continuous improvements on the basis of the Doherty technology to achieve the continuous improvement of efficiency.

In the traditional RF power amplifier, the Doherty structure is only applied to the final stage, and the driver stage and the final stage use the same type of power amplifiers, whose advantages are that: the supply voltages and the bias mode are the same, thus the design of the bias circuit is simple; since the amplifiers are of the same type, the discretion of the mass production is relatively easy to be controlled. However, a fact that cannot be ignored is that: the industry's leading LDMOS device has been developed to the eighth generation, and its cost is low, but its performance has very limited room for improvement, which cannot meet the environmental protection requirements; in addition, although the efficiency of power amplifier is primarily determined by the final stage, the final stage provides 90% of the operating current, thus further enhancing the efficiency of the final stage has great significance, but the 10% provided by the driver stage cannot be ignored increasingly, therefore, it also needs to improve the circuit of the driver stage.

From the signal power spectrum distribution of different standards of communication systems, the 70% -80% energy output by the power amplifier is concentrated near the average power, that is, most of the operating current of the final stage power amplifier using the Doherty technology is provided by the Carrier amplifier, thus enhancing the efficiency of the Carrier amplifier of the final stage has great significance in improving the efficiency of the entire power amplifier. Meanwhile, further enhancing the efficiency of the driver stage can also better realize the efficiency improvement of the entire power amplifier.

### Summary of the Invention

The technical problem to be solved in the present invention is to provide a power amplifier apparatus and a power amplifier circuit to solve the problem that the efficiency of a power amplifier cannot meet the requirements.

To solve the above technical problem, the present invention provides a power amplifier apparatus, the apparatus comprises one or more driver stage power amplifier circuits in a series connection as well as a final stage power amplifier circuit connecting with the output end of the last one driver stage power amplifier circuit, and both the driver stage power amplifier circuit and the final stage power amplifier circuit use the Doherty circuit structure, and said driver stage power amplifier circuits use Lateral double-diffused metal-oxide semiconductor (LDMOS) to implement a Carrier amplifier and a Peak amplifier of the Doherty circuit structure, the final stage power amplifier circuit uses a High Voltage Heterojunction Bipolar Transistor (HVHBT) power amplifier to achieve the Carrier amplifier and the Peak amplifier with the Doherty circuit structure.

To solve the above technical problem, the present invention provides another power amplifier apparatus, the apparatus comprises one or more driver stage power amplifier circuits in a series connection as well as a final stage power amplifier circuit connecting with the output end of the last one driver stage power amplifier circuit, and both the driver stage power amplifier circuit and the final stage power amplifier circuit use the Doherty circuit structure, and the driver stage power amplifier circuit and the final stage power amplifier circuit use the High Voltage Heterojunction Bipolar Transistor (HVHBT) power amplifiers to achieve the Carrier amplifier and the Peak amplifier of the Doherty circuit structure.

To solve the above technical problem, the present invention provides a power amplifier circuit of the power amplifier apparatus, and the power amplifier circuit uses the Doherty circuit structure, and the power amplifier circuit uses the High Voltage Heterojunction Bipolar Transistor (HVHBT) power amplifier to achieve the Carrier amplifier and the Peak amplifier of the Doherty circuit structure.

Preferably, the power amplifier circuit is the driver stage or the final stage of the power amplifier apparatus.

To solve the above technical problem, the present invention provides a power amplifier circuit of the power amplifier apparatus, and the power amplifier circuit comprises:
a power divider sub-circuit;
a carrier amplifier connecting with the output end of the power divider sub-circuit, and the carrier amplifier is achieved with a high voltage heterojunction bipolar transistor (HVHBT) power amplifier;
at least one peak amplifier connecting with the output end of the power divider sub-circuit, the carrier amplifier is implemented with a high voltage heterojunction bipolar transistor (HVHBT) power amplifier;
a power combiner sub-circuit connecting with the output ends of the carrier amplifier and the peak amplifier.

Preferably, the power amplifier circuit is the driver stage or the final stage of the power amplifier apparatus.

The power amplifier apparatus and the power amplifier circuit in the present invention use the Doherty technology and provide a new combination of the Carrier amplifier and the Peak amplifier, and compared to the related art, it can improve the efficiency of the power amplifier.

### Brief Description of Drawings

FIG. 1 is a block diagram of a conventional Doherty power amplifier;
FIG. 2 is a schematic diagram of the Doherty circuit structure;
FIG. 3 is a schematic diagram of a first embodiment of the present invention;
FIG. 4 is a schematic diagram of a second embodiment of the present invention;
FIG. 5 is a schematic diagram of a third embodiment of the present invention;
FIG. 6 is a schematic diagram of a fourth embodiment of the present invention.

### Preferred Embodiments of the Present Invention

The power amplifier apparatus of the present invention uses the high efficient Doherty circuit structure in the final stage power amplifier circuit and the driver stage power amplifier circuit, meanwhile, the driver stage amplifier and the final stage amplifier are newly combined, and the new combination architecture is used to achieve the significant improvement of the overall Doherty power amplifier efficiency.

Particularly related to the present invention, the power amplifier apparatus of the present invention comprises one or more driver stage power amplifier circuits in a series connection, as well as the final stage power amplifier circuit connecting with the output end of the last one driver stage power amplifier circuit, in particular, the driver stage power amplifier circuit in the present invention uses the Doherty circuit structure.

Specifically, as shown in FIG. 2, the Doherty circuit structure comprises: the power divider sub-circuit 10, one main amplifier 20 and at least one auxiliary amplifier 30 connecting with the output end of the power divider sub-circuit 10, as well as the power combiner sub-circuit 40 connecting to the output ends of the main amplifier and auxiliary amplifier.

Understandably, the main amplifier 20, also known as the Carrier amplifier, provides the function of main power amplification, such as continuing to provide power amplification. The auxiliary amplifier, also known as the Peak amplifier, provides the auxiliary power amplification, for example, it only works under certain conditions (for example, when the preset peak is achieved). As shown in FIG. 1, the power divider sub-circuit 10 comprises a series of functional devices such as the power divider, the 90 degree - a quarter of wavelength line, and the phase offset line and so on, and the power combiner sub-circuit 40 comprises a series of functional devices such as the 90 degree - a quarter of wavelength line, the phase offset line, and the impedance transformer and so on; the specific device type, model and connection relationship are designed, selected and matched according to specific requirements and are not limited in the present invention.

The carrier amplifier and the peak amplifier can be achieved with various types of power amplifiers, preferably with the lateral double-diffused metal oxide semiconductor (LDMOS) power amplifier, alternatively, both the carrier amplifier and the peak amplifier use the high voltage heterojunction bipolar transistor (HVHBT) power amplifiers.

The HVHBT is a HBT processing device that is able to work under high voltage, and the high voltage refers to an operating voltage above 12V. It comprises but not limited to the Tripower series power amplifier devices from the U.S. Triquint Company.

In the related art, the final stage power amplifier circuit is also implemented with the Doherty structural circuit shown in FIG. 2, preferably, the high voltage heterojunction bipolar transistor (HVHBT) power amplifier is used to achieve the functions of the main power amplification and the auxiliary power amplification.

In the following, the embodiments of the present invention will be described in detail with combination of the accompanying drawings. It should be noted that without conflict, the embodiments and the features of the embodiments in this application can be combined with each other.

### The first embodiment

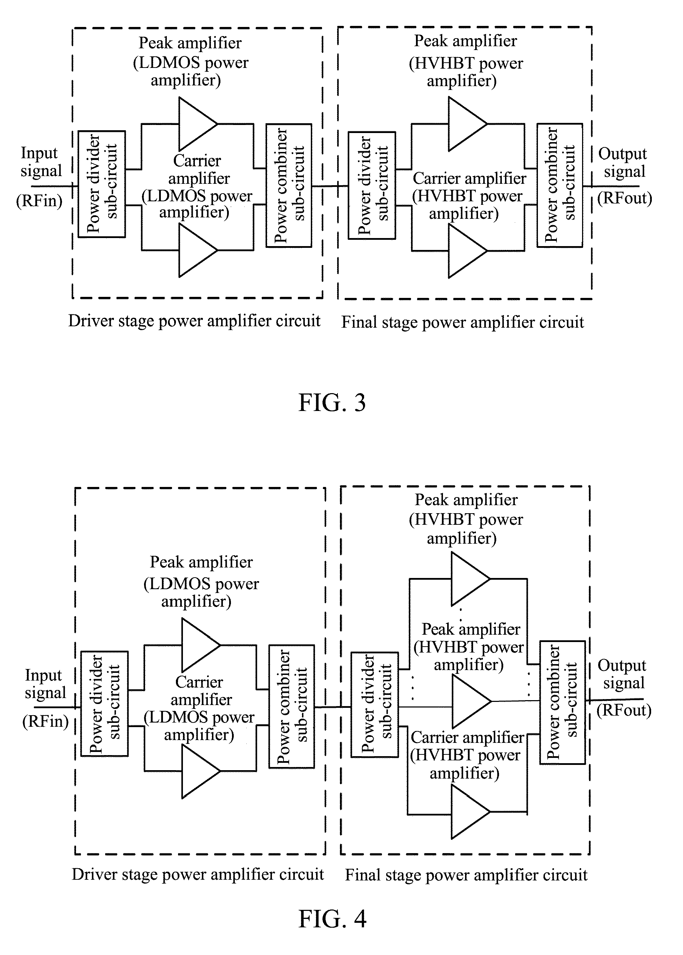

The first embodiment of the power amplifier apparatus is shown in FIG. 3, the driver stage in this embodiment uses a two-path Doherty structural circuit and uses the LDMOS power amplifiers to achieve the functions of the main power amplification and the auxiliary power amplification, and the final stage uses the two-path Doherty structural circuit and uses the HVHBT power amplifier to achieve the function of the main power amplification and uses the LDMOS power amplifier to realize the function of the auxiliary power amplification.

Specifically, the driver stage amplification part is achieved with the Doherty circuit structure; its Carrier amplifier and Peak amplifier use the Lateral double-diffused metal-oxide semiconductor (LDMOS, based on Si) power amplifiers;
at the same time when applying the LDMOS power amplifier in the driver stage to achieve the Doherty circuit, the High Voltage Heterojunction Bipolar Transistor (HVHBT, based on the GaAs) power amplifier is used in the final stage to achieve the two-path Doherty circuit structure.

For the final stage two-path Doherty structure (including the traditional two-path symmetrical Doherty, the asymmetric Doherty and so on) as well as the architecture of one Carrier plus one Peak evolved on this basis, the HVHBT power amplifiers can be used as the Carrier amplifier and the Peak amplifier to achieve the improvement of efficiency, as shown in FIG. 2.

### The second embodiment

The second embodiment of the power amplifier apparatus is shown in FIG. 4, the driver stage in this embodiment uses the two-path Doherty structural circuit and uses the LDMOS power amplifiers to achieve the functions of the main power amplification and the auxiliary power amplification, and the final stage uses the two-path Doherty structural circuit and uses the HVHBT power amplifier to achieve the function of the main power amplification and uses the LDMOS power amplifier to realize the function of the auxiliary power amplification.

Specifically, the driver stage amplification part is achieved with the Doherty circuit structure, and its Carrier amplifier and Peak amplifier use the Lateral double-diffused metal-oxide semiconductor (LDMOS, based on Si) power amplifiers;
at the same time when using the Doherty circuit in the driver stage, the final stage also uses the newly combined multi-path Doherty circuit structure for implementation.

For the final stage multi-path Doherty structure as well as the architecture of one Carrier plus multiple Peaks evolved on the basis of the Doherty structure, the HVHBT power amplifiers can be used as the Carrier amplifier and multiple Peak amplifiers to achieve the improvement of efficiency.

### The third embodiment

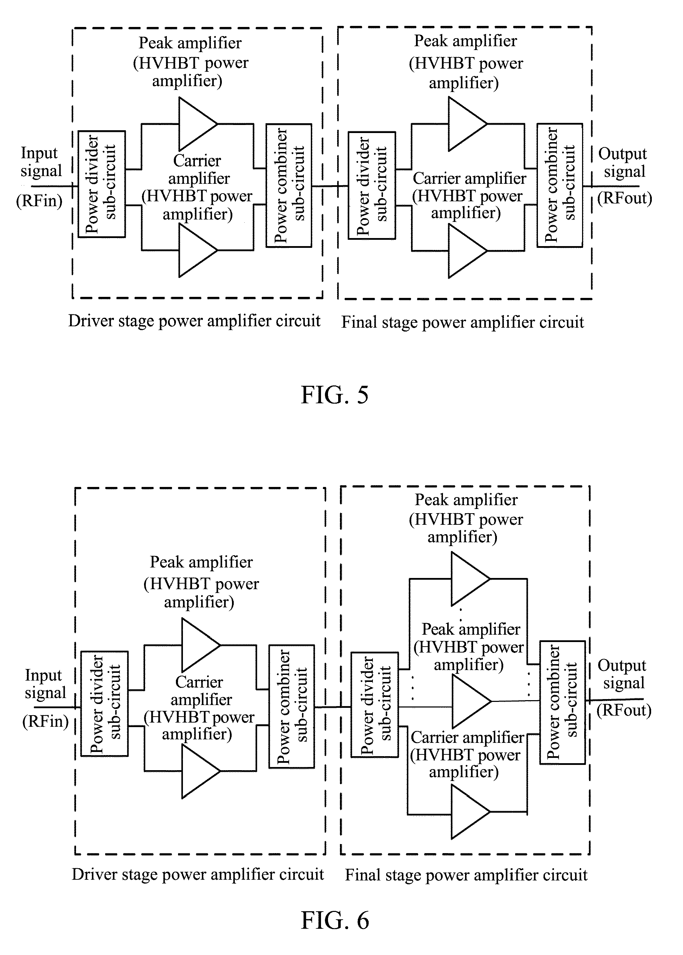

The third embodiment of the power amplifier apparatus is shown in FIG. 5, the circuit structures of the third embodiment and the first embodiment are the same, and the difference is that the driver stage Carrier amplifier and Peak amplifier use the HVHBT power amplifiers.

### The fourth embodiment

The fourth embodiment of the power amplifier apparatus is shown in FIG. 6, the circuit structures of the fourth embodiment and the second embodiment are the same, and the difference is that the driver stage Carrier amplifier and Peak amplifier use the HVHBT power amplifiers.

The key point of the present invention is: both the driver stage and the final stage use the high efficient Doherty circuit structure to improve the overall efficiency; meanwhile, the advantage of the high efficiency of the HVHBT power amplifier is fully utilized to act as the driver stage or the final stage Carrier and Peak amplifiers to improve the efficiency and achieve the optimal performance; moreover, with the combination of the advantages, such as the high maturity, low cost, and the full range of middle power devices, of the LDMOS power amplifier technology, it is used as the driver stage Carrier and Peak amplifiers to finally achieve the maximum improvement of the performance.

With the method and device of the present invention, compared with current Doherty power amplifiers of which the driver stage uses the CLASS AB mode and the final stage Carrier and Peak amplifiers use the LDMOS, the entire power amplification efficiency can be significantly improved;

The development of LDMOS device is very mature, wherein the middle power devices have full range of types and their cost is low. The driver stage uses the LDMOS device + the Doherty structure, which not only improves the efficiency and but also ensures the cost;
the final stage uses the HVHBT device + the Doherty structure, which can achieve the maximum improvement of the power amplification efficiency.

The specific steps for implementing the power amplifier apparatus of the present invention comprise:
1, the models of the HVHBT power amplifier used in the final stage Carrier amplifier are determined according to different implementation requirements;
2, the Doherty structures to be used are compared, analyzed and determined according to different implementation requirements;
3. the models of the HVHBT power amplifier used in the final stage Peak amplifier are determined according to the different implementation requirements;
4, according to the gain of the final stage, the models of the HVHBT power amplifier or the LDMOS power amplifier used in the driver stage Carrier amplifier and the models of the HVHBT power amplifier or the LDMOS power amplifier used in the Peak amplifier are determined;
5. the matching design of the final stage amplifiers and the driver stage amplifiers as well as the design of the power dividing part and power combination part in the block diagram are completed;
6, the design of the rest parts of the apparatus in the present invention is completed.

### For example:

According to the 55W Doherty power amplifier design of the 2.1 GHz UMTS system applications (PAR: 6dB), it needs to use two amplifiers whose total saturation power is at least more than 200W to achieve the design of the final stage. With the combination of the existing devices from the power amplifier manufacturers, two 120W LDMOS power amplifiers can be utilized for implementation through the symmetric Doherty structure, and in accordance with the industry's current device level, its single final stage power amplification efficiency is about 52%; when the method of the present invention is utilized for implementation (both the Carrier amplifier and the Peak amplifier use the HVHBT 120W power amplifiers), the single final stage power amplification efficiency is about 57%, improving nearly 10%.

For the design of Doherty driver stage, since the final stage uses the saturation power which is at least more than 200W, the gain of the current 2.1GHz final stage power amplifier Doherty is about 16dB, therefore, the driver stage can use two 10W LDMOS power amplifiers to design the Doherty driver stage amplification part, therefore, compared with the original CLASS AB design, the driver stage efficiency can be improved by about 20% (for example: the efficiency of using the CLASS AB to design the driver stage is 15%, and it can be up to 18% when using the Doherty design).

Therefore, with the method and device of the present invention, the overall power amplifier efficiency can be greatly improved.

In addition, the present invention also provides a power amplifier circuit of the power amplifier apparatus, and the final stage power amplifier circuit uses the Doherty circuit structure and uses the high voltage heterojunction bipolar transistor (HVHBT) power amplifier to achieve the Carrier amplifier and Peak amplifier with the Doherty circuit structure.

Specifically, the power amplifier circuit is the driver stage or the final stage of the power amplifier apparatus, comprising:
the power divider sub-circuit 10;
the carrier amplifier 20 connecting with the output end of the power divider sub-circuit, wherein the carrier amplifier is achieved with a high voltage heterojunction bipolar transistor (HVHBT) power amplifier;
at least one peak amplifier 30 connecting to the output end of the power divider sub-circuit, wherein the peak amplifier is implemented with a high voltage heterojunction bipolar transistor (HVHBT) power amplifier;
the power combiner sub-circuit 40 connecting with the output ends of the carrier amplifier and the peak amplifier.

In summary, the implementation of the present invention is simple, and its design and debugging are convenient, and those skilled in the field can easily implement the present invention in accordance with this specification. Within the working frequency band range of the Doherty power amplifier, the efficiency indicator thereof can be improved greatly, and the apparatus can be widely used in the design of a variety of Doherty power amplifiers.

The purpose of the present invention is to achieve the overall Doherty power amplification efficiency dramatically with a new combination structure of the driver stage amplifier and the final stage amplifier and by using the high efficient circuit structure in the final stage and the driver stage amplifiers.

### Industrial Applicability

The power amplifier apparatus and the power amplifier circuit in the present invention use the Doherty technology and provide a new combination of the Carrier amplifier and the Peak amplifier, and compared to existing technologies, it can enhance the efficiency of the power amplification.

## Claims

1. A power amplifier apparatus, comprising one or more driver stage power amplifier circuits in a series connection and a final stage power amplifier circuit connecting with a output end of last one driver stage power amplifier circuit, wherein both the driver stage power amplifier circuit and the final stage power amplifier circuit use a Doherty circuit structure, and said driver stage power amplifier circuit uses Lateral double-diffused metal-oxide semiconductor (LDMOS) to implement a Carrier amplifier and a Peak amplifier of the Doherty circuit structure, and the final stage power amplifier circuit uses High Voltage Heterojunction Bipolar Transistor (HVHBT) to implement the Carrier amplifier and Peak amplifier of the Doherty circuit structure.

2. A power amplifier apparatus, comprising one or more driver stage power amplifier circuits in a series connection as well as a final stage power amplifier circuit connecting with a output end of last one driver stage power amplifier circuit, wherein both the driver stage power amplifier circuit and the final stage power amplifier circuit use a Doherty circuit structure, and the driver stage power amplifier circuit and the final stage power amplifier circuit use High Voltage Heterojunction Bipolar Transistor (HVHBT) power amplifiers to implement a Carrier amplifier and a Peak amplifier of the Doherty circuit structure.

3. A power amplifier circuit of power amplifier apparatus, using a Doherty circuit structure, wherein the power amplifier circuit uses a High Voltage Heterojunction Bipolar Transistor (HVHBT) power amplifier to implement a Carrier amplifier and a Peak amplifier of the Doherty circuit structure.

4. The power amplifier circuit of claim 3, wherein the power amplifier circuit is a driver stage or a final stage of the power amplifier apparatus.

5. A power amplifier circuit of power amplifier apparatus, comprising:
a power divider sub-circuit;
a carrier amplifier connecting with a output end of the power divider sub-circuit, wherein the carrier power amplifier is implemented with a high voltage heterojunction bipolar transistor (HVHBT) power amplifier;
at least one peak amplifier connecting with the output end of the power divider sub-circuit, wherein the carrier amplifier is implemented with the HVHBT power amplifier; and
a power combiner sub-circuit connecting with output ends of the carrier amplifier and the peak amplifier.

6. The power amplifier circuit of claim 5, wherein, the power amplifier circuit is a driver stage or a final stage of the power amplifier apparatus.
